# FASCICULE DE BREVET EUROPEEN

(11) **EP 0 681 421 B1**
(45) Date de publication et mention de la délivrance du brevet: **20.01.1999**
(21) Numéro de dépôt: 95400945.2
(22) Date de dépôt: 26.04.1995
(51) Int. Cl.: H05K 7/14

(54) **Dispositif d'automatisation modulaire**
Modulares Automatisierungsgerät
Modular automation device

(30) Priorité: 06.05.1994 FR 9405713
(43) Date de publication de la demande: 08.11.1995
(73) Titulaire: Schneider Automation, 06560 Valbonne (FR)
(72) Inventeur: Malgouires, Pascal, F-06150 Cannes la Bocca (FR)
(74) Mandataire: Carias, Alain

(56) Documents cités:
- EP-A- 0 317 464
- DE-B- 1 262 383
- GB-A- 2 115 062
- NTIS TECH NOTES, Mai 1990 SPRINGFIELD, VA US, page 427 XP 000137394 MATTEI BUCK WILLIAMS 'Perpendicular-Force Latch'

## Description

La présente invention concerne un dispositif d'automatisation, notamment un automate programmable, de type modulaire comprenant un châssis qui comporte des parois horizontales et verticales et qui délimite un volume interne équipé d'éléments de guidage rectiligne, plusieurs modules fonctionnels équipés à l'arrière d'un connecteur et à l'avant d'un connecteur ou d'un bornier, chaque module pouvant être d'une part introduit dans le volume interne du châssis à l'aide des éléments de guidage et d'autre part immobilisé en position de connexion par un organe de verrouillage.

Il existe déjà de nombreuses réalisations de tels dispositifs. Il est ainsi par exemple connu, d'après le document EP- 317 464, notamment figures 4 à 6 et description correspondante, de loger dans un châssis plusieurs boîtiers blindés disposés côte à côte. Chacun de ces boîtiers peut recevoir plusieurs boîtiers superposés qui se verrouillent au moyen de leviers pivotants. Ces leviers s'accrochent dans des encoches frontales prévues dans les bords antérieurs du boîtier blindé.

Par leur présence en saillie à l'avant du châssis, les leviers entraînent une fragilité mécanique du dispositif. Or il serait souhaitable d'une part d'assurer par des moyens peu fragiles un verrouillage irréprochable des modules fonctionnels dans le châssis pour supporter les vibrations rencontrées notamment en milieu industriel, tout en conservant une grande compacité du dispositif. D'autre part, il serait utile de pouvoir loger indifféremment dans le châssis, en gardant à celui-ci une grande simplicité, des modules fonctionnels occupant toute la hauteur, ou seulement la moitié de la hauteur, du châssis.

L'invention a pour but de répondre à ces desiderata par une structure adaptée du dispositif.

Selon l'invention, le volume interne du châssis est partagé en compartiments séparés par des cloisons verticales et logeant chacun au moins un module ; l'organe de verrouillage est constitué par un levier latéral plat apte à pivoter sur un tourillon solidaire d'une paroi latérale du module ou respectivement d'une cloison verticale du châssis, entre une position de déblocage et une position de blocage ; chaque cloison verticale ou respectivement paroi latérale comprend une prise fixe de verrouillage en faible saillie vers l'intérieur du compartiment, le levier de verrouillage coopérant avec la prise à la manière d'une came jusqu'à la position de blocage ; un espace est prévu pour loger la prise et permettre le pivotement du levier.

La description qui suit est faite en regard des dessins annexés pour expliciter les points caractéristiques et les résultats de l'invention :
- la figure 1 représente en perspective un châssis d'automate programmable conforme à l'invention ;
- la figure 2 est une vue de face schématique de l'automate programmable de la figure 1;
- la figure 3 est une vue en coupe d'un module d'interface selon le plan III-III ;
- la figure 4 représente en perspective avant un grand module équipé d'un bornier de câblage ;
- la figure 5 représente en perspective arrière un petit module ;
- les figures 6 et 7 sont des vues latérales en coupe d'un module en position d'introduction et respectivement en position verrouillée ;
- la figure 8 montre à plus grande échelle le détail A de la figure 3 ;
- les figures 9 à 11 montrent de côté un mode de réalisation préféré du levier de verrouillage.

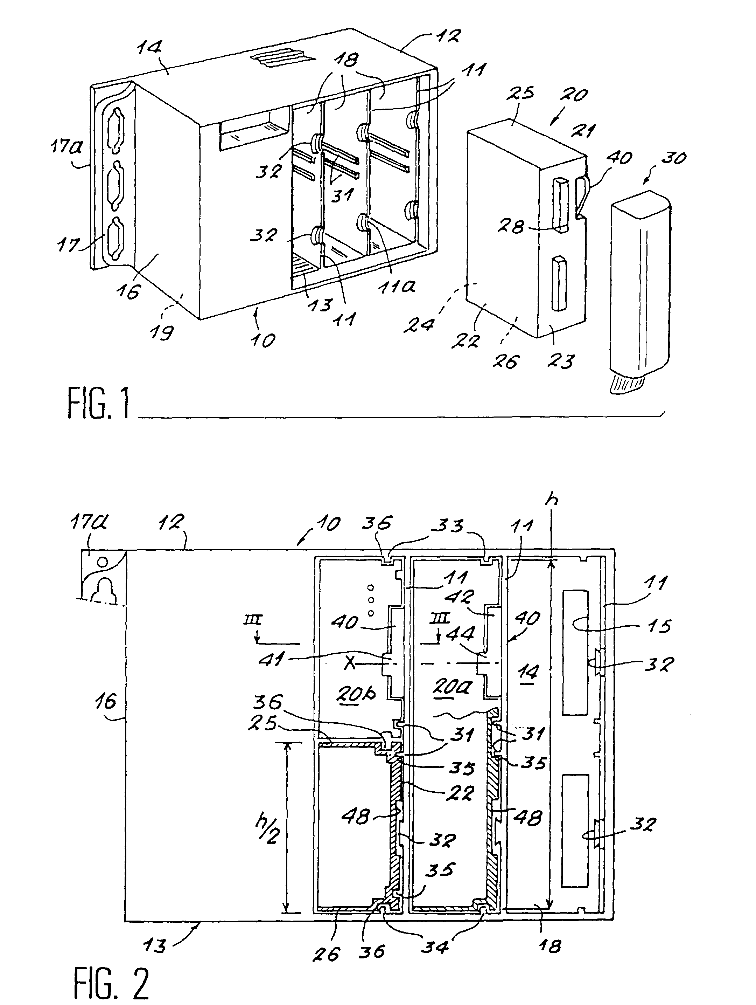

L'automate programmable des figures 1 et 2 comprend un châssis 10 moulé en matière isolante et doté de cloisons verticales latérales 11, d'une paroi horizontale supérieure 12 et d'une paroi horizontale inférieure 13 munies de fentes de convection, ainsi que d'une paroi verticale arrière 14 dotée d'évidements 15 pour le passage de connecteurs arrière des modules. Des parois latérales 16 d'extrémité sont munies d'oreilles 17 pour le passage de connecteurs. Des blindages peuvent être rapportés sur ou dans le châssis ; en particulier une embase 17a peut être rapportée à l'arrière du châssis pour servir d'organe de liaison de masse et d'organe de fixation à un support.

Le châssis 10 définit ainsi un volume interne partagé par les cloisons verticales successives 11 en compartiments modulaires 18 dont chacun est destiné à loger, soit un module fonctionnel d'interface 20a de hauteur h, dit "grand module", soit deux modules fonctionnels d'interface 20b de hauteur sensiblement égale à h/2, dits "petits modules", respectivement illustrés au centre et à gauche sur la figure 2. Le châssis 10 comprend également à côté des compartiments 18 un compartiment 19 pour une unité de traitement et/ou d'alimentation.

Les modules d'interface 20 comprennent des boîtiers parallélépipédiques 21 présentant des parois verticales latérales 22, des parois verticales avant 23 et arrière 24, ainsi que des parois horizontales haute et basse 25, 26 ; ils logent au moins un circuit imprimé équipé à l'avant d'un connecteur avant 28 et à l'arrière d'un connecteur arrière 29. Le connecteur avant est prévu pour se connecter à un bornier de câblage 30 qui se fixe par l'avant contre la paroi 23 du boîtier du module et dont les conducteurs sont reliés à des organes extérieurs d'une machine ou d'un système automatisé contrôlé ou conduit par l'automate ; le connecteur arrière est prévu pour assurer la connexion avec un connecteur complémentaire fixe prévu sur un circuit imprimé ou bus d'interconnexion arrière via les évidements 15.

Chaque cloison verticale 11 située entre deux compartiments comprend d'un côté des nervures horizontales de guidage 31, en nombre pair et par exemple au nombre de deux, pour pouvoir guider des grands modules 20a ou des petits modules 20b ; elle comprend du même côté une prise fixe de verrouillage 32 venue de moulage, constituant une came présentement en forme de haricot et dont le rôle sera expliqué plus loin. Il va de soi que les éléments 31, 32 peuvent être prévus de part et d'autre de la cloison.

Les parois horizontales 12, 13 du châssis comportent dans chaque compartiment au moins une nervure de guidage 33, respectivement 34, pour les modules d'interface.

Chaque module d'interface comprend, en saillie à partir de sa paroi verticale 22 adjacente à une cloison 11, au moins une rainure 35 coopérant avec une nervure de guidage associée 31 et en saillie à partir de ses parois horizontales 25, 26, au moins une rainure 36 coopérant avec une nervure de guidage associée 33, 34. Les nervures et rainures peuvent bien entendu être interverties.

Il convient de noter qu'aucune cloison horizontale n'est prévue dans le châssis pour séparer deux petits modules 20b adjacents logés dans un même compartiment.

Pour éviter de devoir fixer chaque module au châssis à l'aide de moyens de fixation tels que des vis, la paroi verticale latérale 22 du boîtier 21 du module est équipée d'un levier latéral de verrouillage 40 destiné à coopérer avec la came fixe de verrouillage 32 venue de moulage avec la cloison 11.

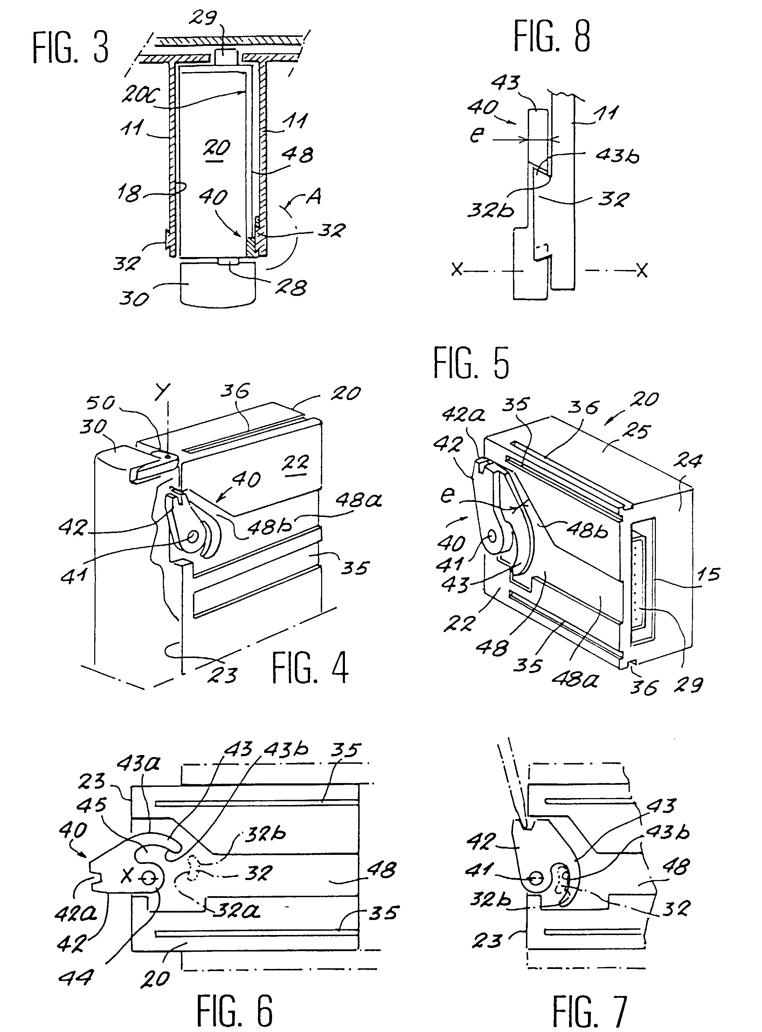

Le levier 40 est monté pivotant sur un tourillon 41 d'axe horizontal X lié à une paroi latérale 22 du boîtier 21 du module. L'axe X est situé sensiblement au niveau du milieu du connecteur arrière 29. Le levier est une pièce en matière plastique montée pivotante sur une enveloppe métallique 20c qui forme plan de masse, comprend les parois 22 et 24 et qui, en vue de dessus, a la forme d'un L (fig. 3). Le levier est plat, c'est-à-dire que son épaisseur est faible comparativement à la largeur du compartiment 18. Il comprend d'une part un bras antérieur de manoeuvre 42 muni d'une encoche 42a pour recevoir l'extrémité d'un outil et destiné à la manoeuvre, d'autre part un bras postérieur d'accrochage 43 en forme de crochet et une partie centrale de palier 44. Près de la partie centrale 44 et vers celle-ci, le bras d'accrochage est bordé par une encoche incurvée 45 dont la forme est agencée pour permettre un serrage positif et résister aux vibrations du levier sur la came 32. Pour tendre à rapprocher le module de la cloison 11 en particulier quand les éléments de guidage 31 et de verrouillage 32 ne sont prévus que d'un côté de la cloison, un bord interne 43b du bras 43 situé vers l'encoche 45 présente une dépouille ou pente convenablement orientée, de même que le bord correspondant 32b de la came 32 (figure 7).

On notera que le bras d'accrochage 43 est plus mince que le bras de manoeuvre 42 ; en particulier, il a une épaisseur latérale e faible et sensiblement équivalente à celle de la came fixe 32, de manière à se loger dans un espace en léger retrait 48 ménagé dans la paroi latérale 22 du module ; cet espace en retrait 48 comprend une plage arrière horizontale 48a permettant le passage de la came fixe 32 et une plage avant verticale 48b permettant le pivotement du bras d'accrochage.

Lorsque le bornier 30 est assemblé au module, il en masque la face avant 23 et en particulier l'accès au bras de manoeuvre 42 du levier de verrouillage 40 (figure 2), pour éviter d'extraire sous tension le module.

Un évidement concave 11a est prévu sur le bord antérieur de chaque cloison 11 au niveau de la prise de verrouillage 32 pour loger la partie centrale 44 du levier plus épaisse que son bras d'accrochage 43.

Le bomier de câblage est fixé au boîtier 11 du module d'interface par une ou deux vis et/ou par des éléments d'emboîtement ou d'encliquetage. En variante (figure 4), un levier extracteur 50 peut être prévu ; ce levier est associé au bornier - ou au module - pour prendre appui sur la face antérieure 23 du module - ou une face postérieure du bornier - et il est monté pivotant autour d'un axe Y pour provoquer ainsi la rétraction du bornier.

Le montage des modules d'interface dans le châssis s'effectue d'une façon qui va être décrite à l'aide des figures 6 et 7.

Le module 20 est présenté devant le châssis 10 pour être introduit dans celui-ci par translation. Les rainures latérales 35 et supérieure et/ou inférieure 36 du boîtier du module sont engagées sur les nervures correspondantes 31 de la cloison verticale 11 du châssis et 33, 34 des parois horizontales 12, 13 du châssis. La plage horizontale 48a en retrait de la paroi latérale 22 du module permet le passage de la came fixe 32 au cours du coulissement du module. Le levier de verrouillage 40 est mis manuellement dans la position de déblocage indiquée figure 6. S'il ne l'est pas, la butée de la tranche arrière externe 43a de son bras d'accrochage 43 contre la face avant concave 32a de la came 32 provoque le pivotement du levier vers sa position de déblocage.

Pour produire une connexion fiable et résistant aux vibrations du connecteur arrière 29 du module avec le connecteur fixe de bus, on repousse le bras de manoeuvre 42 du levier 40 pour faire pivoter celui-ci vers sa position de blocage indiquée figure 7. Le bras d'accrochage 43 du levier s'engage par sa tranche interne concave 43b contre la face arrière convexe 32b de la came fixe 32. La dépouille de la tranche concave 43b, coopérant avec celle de face convexe 32b, tend à renforcer le serrage du boîtier du module.

Pour déverrouiller le boîtier du module, on engage l'extrémité d'un outil dans l'encoche 42a du bras de manoeuvre 42 du levier et on fait pivoter celui-ci en sens antihoraire (figure 7) jusqu'à sa position de déblocage, puis on extrait le module du châssis.

Le grand module 20a présente une rainure latérale centrale 35 (ou deux telles rainures centrales) agencée pour glisser sur la paire de nervures centrales 31 prévues pour le coulissement de la rainure latérale basse et respectivement haute 35 de deux petits modules 20b lorsque ceux-ci sont logés dans le même compartiment 18.

Dans un mode de réalisation moins avantageux, chaque levier pivotant peut être monté sur une cloison verticale du châssis, la prise de verrouillage correspondante étant prévue sur une paroi verticale du module. Le levier peut bien entendu être monté sur une paroi latérale isolante du module.

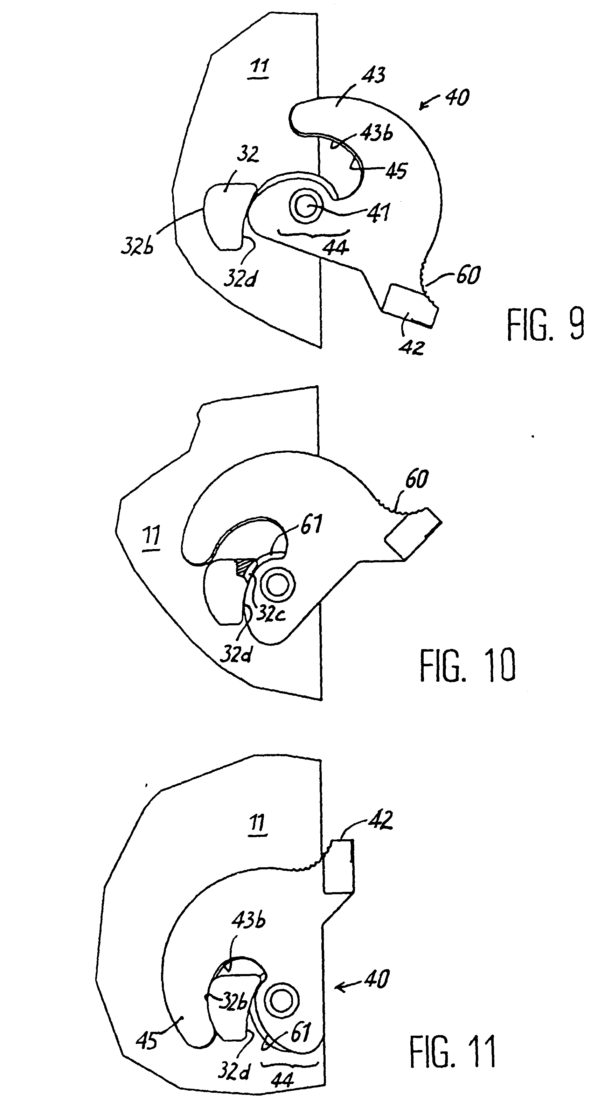

Dans le mode de réalisation des figures 9 à 11, le levier de verrouillage 40 présente, entre le bras de manoeuvre 42 et le bras d'accrochage 43, une zone concave 60 moletée ou striée pour faciliter la prise d'appui de l'utilisateur. Il comprend de plus, sur le côté de sa partie centrale 44 bordant l'encoche incurvée 45, une nervure convexe 61 coopérant avec une rainure concave 32c prévue dans la tranche antérieure concave 32d de la came fixe 32. Le levier 40 est illustré dans ses positions de libération (figure 9), d'engagement ou d'extraction (figure 10) et de verrouillage (figure 11); un effet d'extraction du module est obtenu par la forme de la nervure 61 et de la rainure 32c lorsque l'opérateur fait pivoter le levier en sens horaire pour passer de la position de la figure 11 à celle de la figure 9.

## Revendications

1. Dispositif d'automatisation, notamment automate programmable, de type modulaire comprenant :
- un châssis (10) qui comporte des parois horizontales (12,13) et verticales (11) et qui délimite un volume interne équipé d'éléments de guidage rectiligne,
- plusieurs modules fonctionnels (20) équipés à l'arrière d'un connecteur et à l'avant d'un connecteur ou bornier, chaque module pouvant être d'une part introduit dans le volume interne du châssis à l'aide des éléments de guidage et d'autre part immobilisé en position de connexion par un organe de verrouillage,
caractérisé par le fait que :
- le volume interne du châssis (10) est partagé en compartiments (18) séparés par des cloisons verticales (11) et logeant chacun au moins un module (20a,20b),
- l'organe de verrouillage est constitué par un levier latéral plat (40) apte à pivoter sur un tourillon (41) solidaire d'une paroi latérale (22) du module (20) - ou respectivement d'une cloison verticale (11) - entre une position de déblocage et une position de blocage,
- chaque cloison verticale (11) - ou respectivement paroi latérale (22) - comprend une prise fixe de verrouillage (32) en faible saillie vers l'intérieur du compartiment (18), le levier de verrouillage (40) coopérant avec la prise (32) à la manière d'une came jusqu'à la position de blocage, tandis qu'un espace (48) est prévu pour loger la prise et permettre le pivotement du levier.

2. Dispositif selon la revendication 1, caractérisé par le fait que le levier (40) et la prise de verrouillage (32) présentent une dépouille orientée pour tendre à rapprocher la paroi latérale (22) du module (20) de la cloison (11) du châssis (10).

3. Dispositif selon la revendication 1, caractérisé par le fait que le nombre et la disposition des éléments de guidage (31, 33, 34) sont déterminés pour l'introduction indifférenciée d'un seul module fonctionnel (20a), ou de deux modules fonctionnels (20b) de hauteur moitié, dans chaque compartiment (18).

4. Dispositif selon la revendication 1, caractérisé par le fait qu'un bornier de câblage (30) peut être fixé sur une paroi avant (23) du boîtier (21) du module (20), le bornier masquant l'accès au levier de verrouillage (40).

5. Dispositif selon la revendication 1, caractérisé par le fait que le levier de verrouillage (40) comprend un bras d'accrochage (43) conformé pour mettre le levier en position de déblocage par butée contre la prise de verrouillage (32) en cas d'introduction du module (20) dans le compartiment (18) avec le levier en position de verrouillage.

6. Dispositif selon la revendication 1, caractérisé par le fait que le levier de verrouillage (40) présente un bras de manoeuvre (42) et un bras d'accrochage (43), le bras d'accrochage ayant une épaisseur faible, inférieure à celle du bras de manoeuvre.

7. Dispositif d'automatisation selon la revendication 1, caractérisé par le fait que les prises fixes de verrouillage (32) viennent de moulage avec les cloisons verticales (11) séparant les compartiments (18).

8. Dispositif d'automatisation selon la revendication 1, caractérisé par le fait que la paroi latérale métallique (22) du module (20) sur laquelle pivote le levier de verrouillage (40) est métallique.

9. Dispositif d'automatisation selon la revendication 1, caractérisé par le fait que le levier (40) présente une nervure convexe (61) coopérant avec une rainure concave (32c) de la prise de verrouillage (32) pour faciliter l'extraction du module.

## Patentansprüche

1. Automatisierungsvorrichtung, insbesondere programmierbares Automatisierungsgerät modularen Typs, mit :
- einem Rahmen (10) mit horizontalen (12, 13) und vertikalen (11) Wänden, der ein internes, mit geradlinigen Führungselementen ausgerüstetes Volumen abgrenzt,
- mehreren funktionellen Modulen (20), die hinten mit einem Steckverbinder und vorne mit einem Steckverbinder oder einer Klemmleiste ausgerüstet sind, wobei jedes Modul einerseits mittels Führungselementen in das interne Volumen des Rahmens eingefügt und andererseits von einem Verriegelungsorgan in angeschlossener Position immobilisiert wird,
dadurch gekennzeichnet, dass :
- das interne Volumen des Rahmens (10) in von vertikalen Wänden (11) getrennte Abteile (18) unterteilt wird, die jeweils mindestens ein Modul (20a, 20b) enthalten,
- das Verriegelungsorgan aus einem flachen seitlichen Hebel (40) besteht, der um einen festen Zapfen (41) einer Seitenwand (22) des Moduls (20) - bzw. einer vertikalen Wand (11) - zwischen einer entsperrten und einer gesperrten Position schwenkbar ist,
- jede vertikale Wand (11) - bzw. Seitenwand (22) - einen festen, etwas in das Abteil (18) hineinragenden Verriegelungsstutzen (32) aufweist, wobei der Verriegelungshebel (40) mit dem Stutzen (32) wie ein Nocken zusammenwirkt, bis die gesperrte Position erreicht ist, während ein Raum (48) vorgesehen ist, um den Stutzen aufzunehmen und das Schwenken des Hebels zu ermöglichen.

2. Vorrichtung nach Anspruch 1, dadurch gekennzeichnet, dass der Hebel (40) und der Verriegelungsstutzen (32) eine Schräge aufweisen, die ausgerichtet ist, um die Seitenwand (22) des Moduls (20) der Wand (11) des Rahmens (10) anzunähern.

3. Vorrichtung nach Anspruch 1, dadurch gekennzeichnet, dass die Anzahl und die Anordnung der Führungselemente (31, 33, 34) für die beliebige Einfügung eines einzigen funktionellen Moduls (20a) oder von zwei funktionellen Modulen (20b) halber Höhe im gleichen Abteil (18) vorgesehen sind.

4. Vorrichtung nach Anspruch 1, dadurch gekennzeichnet, dass eine Verkabelungsklemmleiste (30) an einer Vorderwand (23) des Gehäuses (21) des Moduls (20) befestigt werden kann, wobei die Klemmleiste den Zugriff zum Verriegelungshebel (40) verdeckt.

5. Vorrichtung nach Anspruch 1, dadurch gekennzeichnet, dass der Verriegelungshebel (40) einen Einhakhebel (43) aufweist, der so ausgebildet ist, dass er den Hebel durch Anschlag gegen den Verriegelungsstutzen (32) in die entsperrte Position versetzt, wenn das Modul (20) mit dem Hebel in verriegelter Position in das Abteil (18) eingesetzt wird.

6. Vorrichtung nach Anspruch 1, dadurch gekennzeichnet, dass der Verriegelungshebel (40) einen Betätigungsarm (42) und einen Einhakarm (43) aufweist, wobei der Einhakarm eine geringe Dicke hat, die kleiner ist als diejenige des Betätigungsarms.

7. Automatisierungsvorrichtung nach Anspruch 1, dadurch gekennzeichnet, dass die festen Verriegelungsstutzen (32) an die vertikalen, die Abteile (18) trennenden Wände (11) angeformt sind.

8. Automatisierungsvorrichtung nach Anspruch 1, dadurch gekennzeichnet, dass die seitliche Metallwand (22) des Moduls (20), an der der Verriegelungshebel (40) schwenkt, aus Metall besteht.

9. Automatisierungsvorrichtung nach Anspruch 1, dadurch gekennzeichnet, dass der Hebel (40) eine konvexe Rippe (61) aufweist, die mit einer konkaven Kerbe (32c) des Verriegelungsstutzens (32) zusammenwirkt, um das Herausnehmen des Moduls zu erleichtern.

## Claims

1. Automation device, particularly a programmable logical controller, of the modular type comprising:
- a frame (10) that comprises horizontal walls (12, 13) and vertical walls (11) that delimit an internal volume equipped with a straight guide elements,
- several functional modules (20) equipped at the back with a connector and at the front with a connector or terminal block, each module being insertable into the internal volume of the frame using guide elements and also fixed in the connection position by a locking device,
characterized by the fact that:
- the internal volume of the frame (10) is broken down into compartments (18) separated by vertical partitions (11) and each housing at least one module (20a, 20b),
- the locking device is composed of a flat side lever (40) capable of pivoting on a trunnion (41) fixed to a lateral wall (22) of module (20) - or a vertical partition (11) - between a released position and a locking position,
- each vertical position (11) or side wall (22) has a fixed locking connector (32) projecting slightly inwards into the compartment (18), the locking lever (40) working in cooperation with the connector (32) like a cam as far as the blocking position whereas a space (48) is provided to house the connector and enable the lever to pivot.

2. Device according to claim 1, characterized by the fact that the lever (40) and the locking connector (32) are tapered so that they tend to bring the side wall (22) of the module (20) closer to the partition (11) of the frame (10).

3. Device according to claim 1, characterized by the fact that the number and layout of guide elements (31, 33, 34) are determined for undifferentiated insertion of a single functional module (20a) or two functional half height modules (20b) into each compartment (18).

4. Device according to claim 1, characterized by the fact that a wiring terminal block (30) may be fixed onto the front wall (23) of the housing (21) of module (20), the terminal block concealing access to the locking lever (40).

5. Device according to claim 1, characterized by the fact that locking lever (40) comprises an attachment arm (43) shaped to put the lever into the release position by coming into contact with the locking connector (32) in case the module (20) is inserted into the compartment (18) with the lever in the locking position.

6. Device according to claim 1, characterized by the fact that the locking lever (40) has a maneuver arm (42) and an attachment arm (43), the attachment arm being thin, less than the thickness of the maneuver arm.

7. Automation device according to claim 1, characterized by the fact that the fixed locking connectors (32) are molded with the vertical partitions (11) separating the compartments (18).

8. Automation device according to claim 1, characterized by the fact that the metallic side wall (22) of the module (20) on which the locking lever (40) pivots is metallic.

9. Automation device according to claim 1, characterized by the fact that the lever (40) has a convex rib (61) that cooperates with a concave groove (32c) on the locking connector (32) to make it easy to extract the module.
